(19) Europäisches Patentamt / European Patent Office / Office européen des brevets

(11) **EP 4 550 387 A1**

(12) **EUROPEAN PATENT APPLICATION**
published in accordance with Art. 153(4) EPC

(43) Date of publication:
07.05.2025 Bulletin 2025/19

(21) Application number: 23831420.7

(22) Date of filing: 27.06.2023

(51) International Patent Classification (IPC):
*H01L 21/304* (2006.01)

(52) Cooperative Patent Classification (CPC):
H01L 21/304

(86) International application number:
PCT/JP2023/023715

(87) International publication number:
WO 2024/004980 (04.01.2024 Gazette 2024/01)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 01.07.2022 US 202263367542 P

(71) Applicant: MITSUBISHI GAS CHEMICAL
COMPANY, INC.
Chiyoda-ku
Tokyo 100-8324 (JP)

(72) Inventors:
• KAWAI, Ryuichiro
  852129716 Mesa, Arizona (US)
• HORIE, Hiroaki
  Tokyo 125-8601 (JP)
• SHIGETA, Mari
  Tokyo 125-8601 (JP)
• SHIMADA, Kenji
  Tokyo 100-8324 (JP)

(74) Representative: Müller-Boré & Partner
Patentanwälte PartG mbB
Friedenheimer Brücke 21
80639 München (DE)

(54) **SEMICONDUCTOR SUBSTRATE CLEANING COMPOSITION, METHOD FOR CLEANING SEMICONDUCTOR SUBSTRATES, AND METHOD FOR PRODUCING SEMICONDUCTOR SUBSTRATES**

(57) A cleaning composition for semiconductor substrates including:
a component (A): at least one selected from the group consisting of hydrofluoric acid, a salt of hydrofluoric acid, an acid having an anion represented by general formula (a) as a conjugate base, and a salt of an acid having an anion represented by general formula (a) as a conjugate base,

$$[MF_n]^{(n-k)-} \quad (a);$$

a component (B): a compound represented by the following general formula (b):

$$[MO_m(OR)_{k-2m}]_x \quad (b)$$

wherein M is boron, silicon, zirconium, antimony, niobium, aluminum, phosphorus, or titanium, k is the oxidation number of M, m is an integer of 0 or more and k/2 or less, x is a positive integer, R is a hydrogen atom, an alkali metal, or an alkyl group, and n is a coordination number of the fluoride ion to M;
a component (C): an oxidant; and
a component (D): water,
wherein $\alpha$ represented by the following Expression (I) is 0.2 or more and 1.1 or less,

$$\alpha = \frac{[F]}{\sum(n(M) \cdot [M])} \quad (I)$$

**(Cont. next page)**

wherein [F] is the molar concentration of the fluoride ion in the composition, [M] is the molar concentration of M in the composition, and n(M) is the coordination number of the fluoride ion to M.

**Description**

Technical Field

The present invention relates to a cleaning composition for semiconductor substrates, a method for cleaning a semiconductor substrate, and a method for producing a semiconductor substrate.

Background Art

Semiconductor substrates having highly integrated semiconductor devices are generally produced by the following series of steps. Firstly, a conductive thin film such as a metal film to serve as conductive wiring, a low-dielectric-constant interlayer insulating film for insulation between conductive thin films, a hard mask, and the like are formed on a substrate such as a silicon wafer, and then a photoresist is uniformly coated thereon to form a photosensitive layer, which is subjected to selective exposure and a development treatment to prepare a desired photoresist pattern. Subsequently, using the photoresist pattern as a mask, the substrate on which the low-dielectric-constant interlayer insulating film, hard mask, and the like are laminated is dry-etched to form a desired pattern on the substrate. Then, residues produced from the photoresist patterning and dry-etching (hereinafter referred to as "dry-etching residues") and the hard mask are usually removed by oxygen plasma ashing or with a cleaning liquid or the like.

In recent years, titanium nitride is widely used as a hard mask. Further, copper, cobalt, tungsten, and the like are used for metal wiring.

In semiconductor substrates where titanium nitride is used as a hard mask and the titanium nitride coexists on the surface along with metal wiring or a low-dielectric-constant interlayer insulating film, the titanium nitride needs to be removed without corroding the metal wiring and low-dielectric-constant interlayer insulating film.

Cleaning methods that use a corrosion inhibitor are being studied as a method for removing titanium nitride by wet etching without corroding the metal wiring.

For example, PTL1 discloses a liquid composition for the purpose of removing titanium nitride without corroding tungsten and the like. The liquid composition contains an oxidant containing potassium permanganate and a tungsten corrosion inhibitor, which is two types of compound, such as a fluorine compound and an alkyl amine, and the liquid composition has a pH value of 0 to 4.

PTL2 discloses a composition that contains an oxidant, an etching solution, and a solvent, but is substantially free of hydrogen peroxide, which is for the purpose of selectively removing titanium nitride and photoresist etching residues.

PTL3 discloses a composition that contains an oxidant, an etchant, a corrosion inhibitor, a silica source, water, and an organic solvent, and is substantially free of hydrogen peroxide, which is for the purpose of selectively removing titanium nitride and photoresist etching residues.

PTL4 discloses a composition that contains an oxidant, an etchant, a corrosion inhibitor, a chelating agent, and a solvent, which is for the purpose of selectively removing titanium nitride and photoresist etching residues from the surface of a microelectronic device.

Citation List

Patent Literature

PTL1: International Publication No. WO 2015/111684
PTL2: National Publication of International Patent Publication No. JP 2015-506583
PTL3: National Publication of International Patent Publication No. JP 2016-510175
PTL4: National Publication of International Patent Publication No. JP 2016-527707

Summary of Invention

Technical Problem

As semiconductor devices become more highly integrated, the metal wiring in semiconductor substrates also needs to become finer. As the metal wiring becomes finer, there is a concern that the metal atoms forming the wiring will diffuse into the semiconductor device. Under these circumstances, the use of molybdenum, which has low atomic diffusion, for the metal wiring is being studied. However, molybdenum and its oxide film are highly water-soluble, and conventional corrosion inhibitors have little effect in preventing molybdenum corrosion.

For example, if the amount of oxidant used in the liquid composition disclosed in PTL1 is reduced, corrosion of the molybdenum will be suppressed. However, the removal rate of the titanium nitride will decrease. If the amount of fluorine compound is increased to compensate for this, corrosion of the low-dielectric-constant interlayer insulating film composed of silicon dioxide or the like will occur. Thus, when producing semiconductor substrates that use molybdenum for the metal wiring and titanium nitride for the hard mask, it is extremely difficult to remove the titanium nitride without corroding the metal wiring or low-dielectric-constant interlayer insulating film. Therefore, in the production of semiconductor substrates that use molybdenum for the metal wiring and titanium nitride for the hard mask, there is a need for a composition for cleaning semiconductor substrates that can remove titanium nitride without corroding the metal wiring or low-dielectric-constant interlayer insulating film.

The problem to be solved by the present invention is to provide a cleaning composition for semiconductor substrates that can selectively remove titanium nitride from a semiconductor substrate containing titanium nitride, molybdenum, and a low-dielectric-constant interlayer insulating film, a method for cleaning a semiconductor substrate using the cleaning composition for semiconductor substrates, and a method for producing a semiconductor substrate.

Solution to Problem

The present invention provides the following cleaning compositions for semiconductor substrates, method for cleaning a semiconductor substrate, and method for producing a semiconductor substrate.

<1> A cleaning composition for semiconductor substrates, including:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad (a);$$

a component (B): a compound represented by the following general formula (b):

$$[MO_m(OR)_{k-2m}]_x \qquad (b)$$

wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of the fluoride ion to M;
a component (C): an oxidant; and
a component (D): water,
wherein α represented by the following Expression (I) is 0.2 or more and 1.1 or less,

$$\alpha = \frac{[F]}{\sum(n(M) \cdot [M])} \qquad (I)$$

wherein [F] is the molar concentration of the fluoride ion in the composition, [M] is the molar concentration of M in the composition, and n(M) is the coordination number of the fluoride ion to M.
<2> The cleaning composition for semiconductor substrates according to <1>, wherein the component (A) includes at least one selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid.
<3> The cleaning composition for semiconductor substrates according to <1> or <2>, wherein the component (B) includes at least one selected from the group consisting of boric acid, a salt of boric acid, silicon dioxide, silicic acid, a salt of silicic acid, orthosilicic acid, a salt of orthosilicic acid, an alkoxysilane, zirconium oxide, zirconic acid, and a salt of zirconic acid.
<4> The cleaning composition for semiconductor substrates according to any one of <1> to <3>, wherein the component (C) is at least one selected from the group consisting of vanadium(V) oxide, vanadic acid (V), a salt of vanadic acid (V), permanganic acid, a salt of permanganic acid, iodic acid, a salt of iodic acid, orthoperiodic acid, a salt of orthoperiodic acid, perchloric acid, a salt of perchloric acid, diammonium cerium(IV) nitrate, ammonium iron(III)

## EP 4 550 387 A1

sulfate, ammonium peroxodisulfate, iron(III) chloride, ammonium nitrate, t-butyl hydroperoxide, N-methylmorpholine N-oxide, and trimethylamine N-oxide.

<5> The cleaning composition for semiconductor substrates according to any one of <1> to <4>, wherein the cleaning composition is substantially free of hydrogen peroxide, p-benzoquinone, copper(II) nitrate, sodium peroxoborate, bromic acid, and a salt of bromic acid.

<6> The cleaning composition for semiconductor substrates according to any one of <1> to <5>, having a pH of 2 or less.

<7> The cleaning composition for semiconductor substrates according to any one of <1> to <6>, wherein the cleaning composition is used for removing titanium nitride from semiconductor substrates containing titanium nitride, molybdenum and a low-dielectric-constant interlayer insulating film.

<8> The cleaning composition for semiconductor substrates according to any one of <1> to <7>, wherein a content of the component (A) is 0.5 to 10% by mass with respect to the total amount of the cleaning composition for semiconductor substrates.

<9> The cleaning composition for semiconductor substrates according to any one of <1> to <8>, wherein a content of the component (B) is 0.05 to 10% by mass with respect to the total amount of the cleaning composition for semiconductor substrates.

<10> The cleaning composition for semiconductor substrates according to any one of <1> to <9>, wherein a content of the component (C) is 0.0005 to 1% by mass with respect to the total amount of the cleaning composition for semiconductor substrates.

<11> The cleaning composition for semiconductor substrates according to any one of <1> to <10>, wherein the component (A) is at least one selected from the group consisting of an acid having an anion represented by the general formula (a) as a conjugate base and a salt of an acid having an anion represented by the general formula (a) as a conjugate base, and a ratio between the content (mol) of the component (A) and the content (mol) of the component (B), [(A)/(B)], is 1 to 100.

<12> The cleaning composition for semiconductor substrates according to any one of <1> to <11>, wherein when a substrate containing molybdenum and titanium nitride is immersed in the cleaning composition for semiconductor substrates and stored at 60°C, titanium nitride can be removed at a removal rate of 30 Å/min or more, and a ratio between the removal rate of the titanium nitride and the removal rate of the molybdenum is 3 or more.

<13> The cleaning composition for semiconductor substrates according to any one of <1> to <12>, wherein when a substrate containing a low-dielectric-constant interlayer insulating film and titanium nitride is immersed in the cleaning composition for semiconductor substrates and stored at 60°C, the titanium nitride can be removed at a removal rate of 30 Å/min or more, and a ratio between the removal rate of the titanium nitride and the removal rate of the low-dielectric-constant interlayer insulating film is 10 or more.

<14> The cleaning composition for semiconductor substrates according to any one of <7> to <13>, wherein the low-dielectric-constant interlayer insulating film is a PE-TEOS film.

<15> A method for cleaning a semiconductor substrate, including contacting the cleaning composition for semiconductor substrates according to any one of <1> to <14> with a substrate containing titanium nitride, molybdenum, and a low-dielectric-constant interlayer insulating film.

<16> A method for producing a semiconductor substrate, including a step of contacting the cleaning composition for semiconductor substrates according to any one of <1> to <14> with a substrate containing titanium nitride, molybdenum, and a low-dielectric-constant interlayer insulating film.

Advantageous Effects of Invention

The cleaning composition for semiconductor substrates of the present invention can selectively remove titanium nitride from semiconductor substrates containing titanium nitride, molybdenum, and a low-dielectric-constant interlayer insulating film.

In other words, by using the cleaning composition for semiconductor substrates of the present invention, it is possible to remove titanium nitride while suppressing corrosion of, in particular, molybdenum for which an anticorrosive agent is less effective.

Therefore, it is possible to clean and produce semiconductor substrates having finer metal wiring, which enables semiconductor devices to have higher integration.

Description of Embodiments

The present invention provides: a cleaning composition for semiconductor substrates, including:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad (a);$$

a component (B): a compound represented by the following general formula (b):

$$[MO_m(OR)_{k-2m}]_x \qquad (b)$$

wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of a fluoride ion to M;
a component (C): an oxidant; and
a component (D): water,
wherein $\alpha$ represented by the following Expression (I) is 0.2 or more and 1.1 or less; a cleaning method using the cleaning composition for semiconductor substrates; and a method for producing a semiconductor substrate.

$$\alpha = \frac{[F]}{\sum(n(M) \cdot [M])} \qquad (I)$$

In Expression (I), [F] is the molar concentration of the fluoride ion in the composition, [M] is the molar concentration of M in the composition, and n(M) is the coordination number of the fluoride ion to M.

[Cleaning composition for semiconductor substrates]

The cleaning composition for semiconductor substrates of the present invention includes:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad (a);$$

a component (B): a compound represented by the following general formula (b):

$$[MO_m(OR)_{k-2m}]_x \qquad (b)$$

wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of a fluoride ion to M;
a component (C): an oxidant; and
a component (D): water,
wherein $\alpha$ represented by the following Expression (I) is 0.2 or more and 1.1 or less,

$$\alpha = \frac{[F]}{\sum(n(M) \cdot [M])} \qquad (I)$$

wherein [F] is the molar concentration of the fluoride ion in the composition, [M] is the molar concentration of M in the composition, and n(M) is the coordination number of the fluoride ion to M.
By including the above-described components and setting the above-described $\alpha$ to a specific value, the cleaning composition for semiconductor substrates of the present invention can selectively remove titanium nitride from a semiconductor substrate having titanium nitride, molybdenum, and a low-dielectric-constant interlayer insulating film. Although the reason for having such excellent properties is not entirely clear, it is thought to be as follows.
The fluoride ions constituting the component (A) are necessary to remove the titanium nitride, but at the same time they corrode the molybdenum and the low-dielectric-constant interlayer insulating film. It is thought that the nucleophilicity of the fluorine compound can be reduced to a moderate level and corrosion of the molybdenum and the like can be suppressed while removing the titanium nitride by including in the cleaning composition for semiconductor substrates of the present invention a compound, which is component (B), having a specific element as a central element so as to satisfy the above-described specific value of $\alpha$.

The cleaning composition for semiconductor substrates of the present invention will now be described in detail.

<Component (A)>

The cleaning composition for semiconductor substrates of the present invention includes a component (A), which is at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad (a)$$

wherein M is at least one element selected from the group consisting of boron, silicon, zirconium, antimony, niobium, aluminum, phosphorus, and titanium, k is the oxidation number of M, and n is the coordination number of the fluoride ion to M.

That is, the component (A) is at least one selected from the group consisting of hydrofluoric acid, a salt of hydrofluoric acid, an acid having an anion represented by the general formula (a) as a conjugate base, and a salt of an acid having an anion represented by the general formula (a) as a conjugate base.

The component (A) has the role of releasing fluoride ions during cleaning to assist in the removal of titanium nitride.

Among the above-described examples, the component (A) is preferably at least one selected from the group consisting of hydrofluoric acid and an acid having an anion represented by the general formula (a) as a conjugate base, and more preferably is an acid having an anion represented by the general formula (a) as a conjugate base.

Examples of the salt of hydrofluoric acid include sodium fluoride, potassium fluoride, ammonium fluoride, acidic sodium fluoride, acidic potassium fluoride, and acidic ammonium fluoride.

In the formula (a) representing an anion constituting the acid or a salt thereof having the anion represented by the general formula (a) as a conjugate base, M is at least one element selected from the group consisting of boron, silicon, zirconium, antimony, niobium, aluminum, phosphorus, and titanium, preferably at least one element selected from the group consisting of boron, silicon, zirconium, phosphorus and titanium, and more preferably at least one element selected from the group consisting of boron and silicon.

Further, k is the oxidation number of M, and differs depending on M. Generally, the oxidation number is 3 for boron, 4 for silicon, 4 for zirconium, 5 for phosphorus, and 4 for titanium.

n is the coordination number of the fluoride ion to M, and differs depending on M. Generally, the coordination number is 4 for boron, 6 for silicon, 6 for zirconium, 6 for phosphorus, and 6 for titanium.

Examples of the acid having an anion represented by the general formula (a) as a conjugate base include hexafluorosilicic acid, tetrafluoroboric acid, hexafluorozirconic acid, hexafluoroantimonic acid, hexafluoroniobic acid, hexafluoroaluminic acid, hexafluorotitanic acid, and hexafluorophosphoric acid.

Examples of salts of the acid having an anion represented by the general formula (a) as a conjugate base include a salt of hexafluorosilicic acid, a salt of tetrafluoroboric acid, a salt of hexafluorozirconic acid, a salt of hexafluoroantimonic acid, a salt of hexafluoroniobic acid, a salt of hexafluoroaluminis acid, a salt of hexafluorotitanic acid, and a salt of hexafluorophosphoric acid.

Examples of the cation constituting the above-described salts include a sodium ion, a potassium ion, and an ammonium ion. That is, examples of salts of the acid having an anion represented by the general formula (a) as a conjugate base include salts in which a hydrogen ion of the respective acid is replaced with an above-described cation. Specific examples of the salt include ammonium hexafluorophosphate and the like.

From the viewpoint of removing the titanium nitride and suppressing corrosion of the molybdenum and the low-dielectric-constant interlayer insulating film, the component (A) preferably includes at least one selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid, more preferably includes at least one selected from the group consisting of hydrofluoric acid, hexafluorosilicic acid, tetrafluoroboric acid, hexafluorozirconic acid, hexafluorotitanic acid, and hexafluorophosphoric acid, more preferably includes at least one selected from the group consisting of hydrofluoric acid, hexafluorosilicic acid, and tetrafluoroboric acid, and still further preferably includes at least one selected from the group consisting of hexafluorosilicic acid and tetrafluoroboric acid.

In addition, as a preferred embodiment, the component (A) is preferably at least one selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid, more preferably at least one selected from the group consisting of hydrofluoric acid, hexafluorosilicic acid, tetrafluoroboric acid, hexafluorozirconic acid, hexafluorotitanic acid, and hexafluorophosphoric acid, and further preferably at least one selected from the group consisting of hexafluorosilicic acid and tetrafluoroboric acid.

The cleaning composition for semiconductor substrates of the present invention may include only one type of component (A), or may include two or more types of component (A). For example, the cleaning composition may include both hydrofluoric acid and an acid having an anion represented by the general formula (a) as a conjugate base, or may include two or more types of acids having an anion represented by the general formula (a) as a conjugate base.

The content of the component (A) in the cleaning composition for semiconductor substrates of the present invention is, with respect to the total amount of the cleaning composition for semiconductor substrates, preferably 0.5 to 10% by mass, more preferably 1.0 to 8.0% by mass, further preferably 2.0 to 7.0% by mass, and still further preferably 3.0 to 6.0% by mass. By setting the content of the component (A) to be within the above ranges, the titanium nitride can be removed while suppressing corrosion of the molybdenum and the low-dielectric-constant interlayer insulating film.

<Component (B)>

The cleaning composition for semiconductor substrates of the present invention includes a component (B), which is a compound represented by the following general formula (b),

$$[MO_m(OR)_{k-2m}]_x \qquad (b)$$

wherein M is at least one element selected from the group consisting of boron, silicon, zirconium, antimony, niobium, aluminum, phosphorus, and titanium, k is the oxidation number of M, m is an integer of 0 or more and k/2 or less, x is a positive integer, and R is one selected from the group consisting of a hydrogen atom, an alkali metal, and an alkyl group.

The component (B) is thought to both remove the titanium nitride and suppress corrosion of the molybdenum and the low-dielectric-constant interlayer insulating film by reducing the nucleophilicity of the component (A) to a moderate level.

In formula (b) representing the compound of the component (B), M is at least one element selected from the group consisting of boron, silicon, zirconium, antimony, niobium, aluminum, phosphorus, and titanium, preferably at least one element selected from the group consisting of boron, silicon, zirconium, phosphorus, and titanium, and more preferably at least one element selected from the group consisting of boron and silicon.

Further, k is the oxidation number of M, and differs depending on M. Generally, the oxidation number is 3 for boron, 4 for silicon, 4 for zirconium, 5 for phosphorus, and 4 for titanium.

R is one selected from the group consisting of a hydrogen atom, an alkali metal, and an alkyl group. That is, if R is a hydrogen atom, the component (B) is a compound having a hydroxy group, if R is an alkali metal, the component (B) is a salt of an acid having M as the central metal, and if R is an alkyl group, the component (B) is an alkoxide.

m is an integer of 0 or more and k/2 or less. When m is k/2, the component (B) is an oxide of M.

x is a positive integer. When x is 1, the component (B) is a compound that has one M in the molecule. When x is 2 or more, the component (B) is a polymer in which a plurality of compounds having one M in the molecule are bonded together. When x is 2 or more, the component (B) preferably has a cyclic structure.

From the viewpoint of removing the titanium nitride and suppressing corrosion of the molybdenum and the low-dielectric-constant interlayer insulating film, the component (B) preferably includes at least one selected from the group consisting of boric acid, a salt of boric acid, silicon dioxide, silicic acid, a salt of silicic acid, orthosilicic acid, a salt of orthosilicic acid, an alkoxysilane, zirconium oxide, zirconic acid, and a salt of zirconic acid, more preferably includes at least one selected from the group consisting of boric acid, silicon dioxide, silicic acid, and a salt of silicic acid, further preferably includes at least one selected from the group consisting of boric acid, silicon dioxide, and a salt of silicic acid, and still further preferably includes at least one selected from the group consisting of boric acid and a salt of silicic acid.

In addition, as a preferred embodiment, the component (B) is preferably at least one selected from the group consisting of boric acid, a salt of boric acid, silicon dioxide, silicic acid, a salt of silicic acid, orthosilicic acid, a salt of orthosilicic acid, an alkoxysilane, zirconium oxide, zirconic acid, and a salt of zirconic acid, more preferably at least one selected from the group consisting of boric acid, silicon dioxide, silicic acid, and a salt of silicic acid, further preferably at least one selected from the group consisting of boric acid, silicon dioxide, and a salt of silicic acid, and still further preferably at least one selected from the group consisting of boric acid and a salt of silicic acid.

Examples of the cation constituting the above-described salts include a sodium ion, a potassium ion, and an ammonium ion. That is, examples of a salt of boric acid, a salt of silicic acid, a salt of orthosilicic acid, and a salt of zirconic acid include salts in which a hydrogen ion of the respective acid is replaced with an above-described cation. Specific examples of the salt include sodium metasilicate, potassium silicate, and the like.

The cleaning composition for semiconductor substrates of the present invention may include only one type of component (B), or may include two or more types of component (B).

The content of the component (B) in the cleaning composition for semiconductor substrates of the present invention is, with respect to the total amount of the cleaning composition for semiconductor substrates, preferably 0.05 to 10% by mass, more preferably 0.1 to 5.0% by mass, further preferably 0.2 to 4.0% by mass, and still further preferably 0.3 to 2.0% by mass. By setting the content of the component (B) to be within the above ranges, the titanium nitride can be removed while suppressing corrosion of the molybdenum and the low-dielectric-constant interlayer insulating film.

<Component (C): Oxidant>

The cleaning composition for semiconductor substrates of the present invention includes a component (C), which is an oxidant.

The component (C) is included in the composition in order to efficiently remove the titanium nitride.

A commonly known oxidant can be used for the component (C).

Among those, from the viewpoint of the removing titanium nitride and suppressing corrosion of the molybdenum and the low-dielectric-constant interlayer insulating film, the component (C) is preferably at least one selected from the group consisting of vanadium(V) oxide, vanadic acid (V), a salt of vanadic acid (V), permanganic acid, a salt of permanganic acid, iodic acid, a salt of iodic acid, orthoperiodic acid, a salt of orthoperiodic acid, perchloric acid, a salt of perchloric acid, diammonium cerium(IV) nitrate, ammonium iron(III) sulfate, ammonium peroxodisulfate, iron(III) chloride, ammonium nitrate, t-butyl hydroperoxide, N-methylmorpholine N-oxide, and trimethylamine N-oxide, more preferably at least one selected from the group consisting of vanadium(V) oxide, a salt of permanganic acid, iodic acid, a salt of iodic acid, perchloric acid, a salt of perchloric acid, diammonium cerium(IV) nitrate, ammonium iron(III) sulfate, ammonium peroxodisulfate, ammonium nitrate, and N-methylmorpholine N-oxide, further preferably at least one selected from the group consisting of vanadium(V) oxide, a salt of permanganic acid, and iodic acid, still further preferably at least one selected from the group consisting of vanadium(V) oxide and a salt of permanganic acid, and still further preferably a salt of permanganic acid.

Examples of the cation constituting the above-described salts include a sodium ion, a potassium ion, and an ammonium ion. That is, examples of a salt of vanadic acid (V), a salt of permanganic acid, a salt of iodic acid, a salt of orthoperiodic acid, and a salt of perchloric acid include salts in which a hydrogen ion of the respective acid is replaced with an above-described cation. Specific examples of the salt include potassium permanganate and the like.

The cleaning composition for semiconductor substrates of the present invention may include only one type of component (C), or may include two or more types of component (C).

The content of the component (C) in the cleaning composition for semiconductor substrates of the present invention is, with respect to the total amount of the cleaning composition for semiconductor substrates, preferably 0.0005 to 1% by mass, more preferably 0.0008 to 0.2% by mass, further preferably 0.0010 to 0.1% by mass, still further preferably 0.0010 to 0.03% by mass, and still further preferably 0.0015 to 0.01% by mass. By setting the content of the component (C) to be within the above ranges, the titanium nitride can be removed while suppressing corrosion of the molybdenum and the low-dielectric-constant interlayer insulating film.

The problem to be solved by the cleaning composition for semiconductor substrates of the present invention is to suppress corrosion of the molybdenum and the low-dielectric-constant interlayer insulating film during cleaning, and thus it is preferable to avoid using an oxidant having a strong oxidizing power as much as possible, or if such an oxidant is used, preferable to use as small an amount as possible of the oxidant.

It is preferred that the cleaning composition for semiconductor substrates of the present invention is substantially free of hydrogen peroxide, p-benzoquinone, copper(II) nitrate, sodium peroxoborate, bromic acid, and a salt of bromic acid. "Substantially free of" means that the content is equal to or less than an amount that does not impair the effects of the cleaning composition for semiconductor substrates of the present invention.

When hydrogen peroxide, p-benzoquinone, copper(II) nitrate, sodium peroxoborate, bromic acid, or a salt of bromic acid is included, the total content of these is, with respect to the total amount of the cleaning composition for semiconductor substrates, preferably less than 0.0015% by mass, more preferably less than 0.0010% by mass, further preferably less than 0.0008% by mass, and still further preferably less than 0.0005% by mass. Still further preferably, hydrogen peroxide, p-benzoquinone, copper(II) nitrate, sodium peroxoborate, bromic acid, and a salt of bromic acid are not included.

<Component (D): Water>

The cleaning composition for semiconductor substrates of the present invention contains a component (D), which is water.

The water is not particularly limited, but it is preferably water from which impurities such as metal ions, organic matter, particles, and the like have been removed by distillation, ion exchange treatment, filter treatment, various adsorption treatments, or the like. Pure water is more preferred, and in particular ultra-high-purity water is preferred.

The water content is the balance after removing the component (A), the component (B), the component (C), and other additives from the cleaning composition for semiconductor substrates of the present invention. The content is preferably 80% by mass or more, and more preferably 90 to 99.5% by mass, with respect to the total amount of the cleaning composition for semiconductor substrates. When the water content is within the above ranges, the effects of the present invention can be exhibited, and it is economically advantageous.

<Properties of the cleaning composition for semiconductor substrates>

The cleaning composition for semiconductor substrates of the present invention includes the component (A), component (B), component (C), and component (D), and $\alpha$ represented by the following expression (I) is 0.2 or more and 1.1 or less,

$$\alpha = \frac{[F]}{\sum(n(M) \cdot [M])} \quad (I)$$

wherein [F] is the molar concentration of the fluoride ions in the composition, [M] is the molar concentration of M in the composition, and n(M) is the coordination number of the fluoride ion to M.

Here, $\alpha$ is the value represented by the expression (I), which is a value indicating the proportion of fluoride ions contained in the component (A) to the element represented by M contained in the component (A) and the component (B).

It is thought that the nucleophilicity of the fluorine compound can be reduced to a moderate level and corrosion of the molybdenum and the like can be suppressed while removing the titanium nitride by setting $\alpha$ in the range of 0.2 or more and 1.1 or less, which allows the element contained in the component (B) to form a fluoro complex (fluorine-coordinated -ate complex) with the fluoride ions contained in the component (A), and fluoride ions to be supplied gradually through an equilibrium reaction.

$\alpha$ is 0.2 or more, preferably 0.4 or more, and more preferably 0.7 or more, and is 1.1 or less, preferably 1.05 or less, and more preferably 1.0 or less. By setting $\alpha$ within the above ranges, the titanium nitride can be removed while suppressing corrosion of the molybdenum and the low-dielectric-constant interlayer insulating film.

In expression (I), $\alpha$ is determined by dividing the molar concentration of fluoride ions in the composition ([F]) by the product of the coordination number of the fluoride ion to M (n(M)) and the molar concentration of M in the composition ([M]).

Here, M is the element used in component (A) and component (B), and is specifically at least one element selected from the group consisting of boron, silicon, zirconium, antimony, niobium, aluminum, phosphorus, and titanium.

When a plurality of elements M are used in component (A) and component (B), $\alpha$ is determined by dividing the molar concentration of fluoride ions in the composition ([F]) by the sum of the products of the coordination number of the fluoride ion to each M (n(M)) and the molar concentration of each M in the composition ([M]).

For example, when M is composed of two types of element, M1 and M2, the denominator on the right side of expression (I) is (n1(M1)·[M1]+n2(M2)·[M2]). Here, [M1] is the molar concentration of M1 in the composition, n1(M1) is the coordination number of the fluoride ion to M1, [M2] is the molar concentration of M2 in the composition, n2(M2) is the coordination number of the fluoride ion to M2.

When the component (A) is at least one selected from the group consisting of an acid having an anion represented by the general formula (a) as a conjugate base and a salt of an acid having an anion represented by the general formula (a) as a conjugate base, the ratio between the content (moles) of the component (A) and the content (moles) of the component (B), [(A)/(B)], is preferably 1 to 100, more preferably 2 to 50, further preferably 4 to 40, still further preferably 4 to 20, and still further preferably 8 to 20. By setting the ratio between the content (moles) of the component (A) and the content (moles) of the component (B) to be within the above ranges, the titanium nitride can be removed while suppressing corrosion of the molybdenum and the low-dielectric-constant interlayer insulating film. The "ratio between the content (moles) of the component (A) and the content (moles) of the component (B)" is the ratio of the content (moles) of the component (A) to the content (moles) of the component (B), [(A)/(B)].

In addition, the "content (moles) of the component (B)" used when calculating the above ratio is, if x in formula (b) representing the compound of the component (B) exceeds 1, the amount obtained by multiplying the actual content of the component (B) contained in the cleaning composition for semiconductor substrates by x.

The pH of the cleaning composition for semiconductor substrates of the present invention is preferably 2 or less, more preferably 1.5 or less, further preferably 1.0 or less, and still further preferably 0.5 or less. By setting the pH to be within the above ranges, corrosion of the molybdenum in particular can be suppressed. The pH can be measured by the method described in the Examples.

As described above, the cleaning composition for semiconductor substrates of the present invention is used to remove the titanium nitride from a semiconductor substrate containing titanium nitride, molybdenum, and a low-dielectric-constant interlayer insulating film. That is, the cleaning composition for semiconductor substrates of the present invention is a cleaning composition for semiconductor substrates that is used to remove the titanium nitride from a semiconductor substrate having titanium nitride, molybdenum, and a low-dielectric-constant interlayer insulating film.

More specifically, the cleaning composition for semiconductor substrates of the present invention is used to remove titanium nitride from semiconductor substrates containing titanium nitride, molybdenum, and a low-dielectric-constant interlayer insulating film. The cleaning composition for semiconductor substrates includes:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad (a);$$

a component (B): a compound represented by the following general formula (b):

$$[MO_m(OR)_{k-2m}]_x \qquad (b)$$

wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of a fluoride ion to M;
a component (C): an oxidant; and
a component (D): water,
wherein $\alpha$ represented by the following Expression (I) is 0.2 or more and 1.1 or less,

$$\alpha = \frac{[F]}{\sum(n(M) \cdot [M])} \qquad (I)$$

wherein [F] is the molar concentration of the fluoride ions in the composition, [M] is the molar concentration of M in the composition, and n(M) is the coordination number of the fluoride ion to M.

It is preferred that the cleaning composition for semiconductor substrates of the present invention can, when a substrate containing molybdenum and titanium nitride is immersed in the cleaning composition for semiconductor substrates and stored at 60°C, remove the titanium nitride at a removal rate of 30 Å/min or more, and that a ratio between the removal rate of the titanium nitride and the removal rate of the molybdenum is 3 or more.

As a result of having the above-described properties, the cleaning composition for semiconductor substrates of the present invention can selectively remove titanium nitride from semiconductor substrates containing molybdenum. In other words, by using the cleaning composition for semiconductor substrates of the present invention, it is possible to remove titanium nitride while suppressing corrosion of, in particular, molybdenum for which an anticorrosive agent is less effective. Therefore, it is possible to clean and produce semiconductor substrates having finer metal wiring, which enables semiconductor devices to have higher integration.

The removal rate of the titanium nitride under the above conditions is preferably 30 Å/min or more, more preferably 100 Å/min or more, and further preferably 150 Å/min or more. The higher the removal rate of the titanium nitride under the above conditions, the more efficiently the titanium nitride can be removed, and thus a higher removal rate is preferable, but the removal rate is generally 2000 Å/min or less.

The removal rate of the molybdenum under the above conditions is preferably 50 Å/min or less, more preferably 30 Å/min or less, and further preferably 25 Å/min or more. The lower the removal rate of the molybdenum under the above conditions, the more corrosion of the molybdenum can be suppressed, and thus a lower removal rate is preferable, but the removal rate is generally 0.1 Å/min or more.

The ratio between the removal rate of the titanium nitride and the removal rate of the molybdenum under the above conditions is preferably 3 or more, more preferably 5 or more, and further preferably 8 or more. The larger the ratio between the removal rate of the titanium nitride and the removal rate of the molybdenum under the above conditions, the more the titanium nitride can be selectively removed from the semiconductor substrate containing molybdenum, and thus a larger ratio is preferable, but the ratio is generally 300 or less.

The specific measurement method and conditions are described in "(2) Etching rate (ER)" in the Examples.

It is preferred that the cleaning composition for semiconductor substrates of the present invention can, when a substrate containing a low-dielectric-constant interlayer insulating film and titanium nitride is immersed in the cleaning composition for semiconductor substrates and stored at 60°C, remove the titanium nitride at a removal rate of 30 Å/min or more, and that a ratio between the removal rate of the titanium nitride and the removal rate of the low-dielectric-constant interlayer insulating film is 10 or more.

As a result of having the above-described properties, the cleaning composition for semiconductor substrates of the present invention can selectively remove titanium nitride from a semiconductor substrate that contains a low-dielectric-constant interlayer insulating film. Therefore, it is possible to clean and produce semiconductor substrates having finer metal wiring, which enables semiconductor devices to have higher integration.

The removal rate of the titanium nitride under the above conditions is preferably 30 Å/min or more, more preferably 100 Å/min or more, and further preferably 150 Å/min or more. The higher the removal rate of the titanium nitride under the above conditions, the more efficiently the titanium nitride can be removed, and thus a higher removal rate is preferable, but the removal rate is generally 2000 Å/min or less.

The removal rate of the low-dielectric-constant interlayer insulating film under the above conditions is preferably 15 Å/min or less, more preferably 10 Å/min or less, and further preferably 6 Å/min or more. The lower the removal rate of the low-dielectric-constant interlayer insulating film under the above conditions, the more the titanium nitride can be selectively removed from the semiconductor substrate containing the low-dielectric-constant interlayer insulating film, and thus a lower removal rate is preferable, but the removal rate is generally 0.1 Å/min or more.

The ratio between the removal rate of the titanium nitride and the removal rate of the low-dielectric-constant interlayer insulating film under the above conditions is preferably 10 or more, more preferably 30 or more, and further preferably 90 or more. The larger the ratio between the removal rate of the titanium nitride and the removal rate of the low-dielectric-constant interlayer insulating film under the above conditions, the more the titanium nitride can be selectively removed from the semiconductor substrate containing the low-dielectric-constant interlayer insulating film, and thus a larger ratio is preferable, but the ratio is generally 500 or less.

The specific measurement method and conditions are described in "(2) Etching rate (ER)" in the Examples.

The low-dielectric-constant interlayer insulating film is preferably a film composed of a silicon compound, more preferably a TEOS film, a silicon dioxide film, or a silicon-containing organic polymer film, further preferably a TEOS film or a silicon dioxide film, and still further preferably a TEOS film.

The silicon dioxide film is preferably a carbon-doped silicon dioxide film.

Among TEOS films, a PE-TEOS film (plasma TEOS film) is preferred.

[Method for cleaning semiconductor substrate]

The method for cleaning a semiconductor substrate of the present invention is a method including contacting the above-described cleaning composition for semiconductor substrates with a substrate containing titanium nitride, molybdenum, and a low-dielectric-constant interlayer insulating film.

More specifically, the method for cleaning a semiconductor substrate of the present invention includes contacting, with a substrate containing titanium nitride, molybdenum, and a low-dielectric-constant interlayer insulating film, a cleaning composition for semiconductor substrates including:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \qquad \text{(a)};$$

a component (B): a compound represented by the following general formula (b):

$$[MO_m(OR)_{k-2m}]_x \qquad \text{(b)}$$

wherein in formulas (a) and (b), M is at least one element selected from the group consisting of boron, silicon, zirconium, antimony, niobium, aluminum, phosphorus, and titanium, $k$ is the oxidation number of M, $m$ is an integer of 0 or more and $k/2$ or less, $x$ is a positive integer, R is one selected from the group consisting of a hydrogen atom, an alkali metal, and an alkyl group, and $n$ is a coordination number of the fluoride ion to M;
a component (C): an oxidant; and
a component (D): water,
wherein $\alpha$ represented by the following Expression (I) is 0.2 or more and 1.1 or less,

$$\alpha = \frac{[F]}{\sum (n(M) \cdot [M])} \quad (I)$$

wherein [F] is the molar concentration of the fluoride ions in the composition, [M] is the molar concentration of M in the composition, and n(M) is the coordination number of the fluoride ion to M.

The cleaning method of the present invention is performed to remove titanium nitride from a semiconductor substrate containing titanium nitride, molybdenum, and a low-dielectric-constant interlayer insulating film. By cleaning the semiconductor substrate using the cleaning method of the present invention, the titanium nitride can be selectively removed from the semiconductor substrate having titanium nitride, molybdenum, and the low-dielectric-constant interlayer insulating film.

In other words, by using the cleaning method of the present invention to clean the substrates, it is possible to remove titanium nitride while suppressing corrosion of, in particular, molybdenum for which an anticorrosive agent is less effective.

Therefore, it is possible to clean and produce semiconductor substrates having finer metal wiring, which enables semiconductor devices to have higher integration.

The temperature during cleaning in the cleaning method of the present invention is not particularly limited, but is preferably 20 to 80°C, and more preferably 25 to 70°C. Further, ultrasonic waves may be used during the cleaning.

The cleaning time in the cleaning method of the present invention is not particularly limited, but is preferably 0.3 to 20 minutes, and more preferably 0.5 to 10 minutes.

In the cleaning method of the present invention, after the cleaning it is preferred to further rinse with a rinsing liquid containing water, alcohol, and the like.

In the cleaning method of the present invention, the method of contacting the cleaning composition for semiconductor substrates of the present invention with the substrate is not particularly limited. For example, a method of contacting the cleaning composition for semiconductor substrates of the present invention with the substrate by dropping (single-wafer spin treatment) or spraying (atomization treatment), or a method of immersing the substrate in the cleaning composition for semiconductor substrates of the present invention may be used. In the present invention, any method may be used, but a method of immersing the substrate in the cleaning composition for semiconductor substrates of the present invention is preferred.

[Method for producing semiconductor substrate]

The method for producing a semiconductor substrate of the present invention includes a step of contacting the above-described cleaning composition for semiconductor substrates with a substrate containing titanium nitride, molybdenum, and a low-dielectric-constant interlayer insulating film.

More specifically, the method for producing a semiconductor substrate of the present invention includes contacting, with a substrate containing titanium nitride, molybdenum, and a low-dielectric-constant interlayer insulating film, a cleaning composition for semiconductor substrates including:

a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

$$[MF_n]^{(n-k)-} \quad (a);$$

a component (B): a compound represented by the following general formula (b):

$$[MO_m(OR)_{k-2m}]_x \quad (b)$$

wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of the fluoride ion to M;
a component (C): an oxidant; and
a component (D): water,
wherein $\alpha$ represented by the following Expression (I) is 0.2 or more and 1.1 or less,

$$\alpha = \frac{[F]}{\sum(n(M) \cdot [M])} \quad (I)$$

wherein [F] is the molar concentration of the fluoride ions in the composition, [M] is the molar concentration of M in the composition, and n(M) is the coordination number of the fluoride ion to M.

A specific method for producing a semiconductor substrate is illustrated below.

First, a barrier insulating film, a low-dielectric-constant interlayer insulating film, a hard mask, and a photoresist are laminated on a substrate such as silicon having a barrier metal, metal wiring, a low-dielectric-constant interlayer insulating film, and optionally a cap metal, the photoresist is then subjected to selective exposure and a development treatment to form a photoresist pattern. Next, this photoresist pattern is transferred onto the hard mask by dry etching. The photoresist pattern is then removed, and the low-dielectric-constant interlayer insulating film and the barrier insulating film are dry etched using the hard mask as an etching mask. Next, the above-described step of contacting the cleaning composition for semiconductor substrates with the substrate is carried out to obtain a semiconductor substrate having a desired metal wiring pattern.

Here, silicon, amorphous silicon, polysilicon, glass, or the like is used for the substrate material. Tantalum, tantalum nitride, ruthenium, manganese, magnesium, cobalt, oxides thereof, or the like is used for the barrier metal.

As described above, the low-dielectric-constant interlayer insulating film is preferably a film composed of a silicon compound, more preferably a TEOS film, a silicon dioxide film, or a silicon-containing organic polymer film, further preferably a TEOS film or a silicon dioxide film, and still further preferably a TEOS film.

The silicon dioxide film is preferably a carbon-doped silicon dioxide film.

Among TEOS films, a PE-TEOS film (plasma TEOS film) is preferred.

Silicon nitride, silicon carbide, silicon nitride carbide, or the like is used for the barrier insulating film. Titanium, titanium nitride, or the like is used for the hard mask, and in the present invention, the hard mask contains titanium nitride.

The metal wiring contains molybdenum. The metal wiring may be composed of elemental molybdenum or a molybdenum alloy, but elemental molybdenum is preferred.

The step of contacting the cleaning composition for semiconductor substrates with the substrate containing titanium nitride, molybdenum, and a low-dielectric-constant interlayer insulating film, which is a step included in the present production method, is preferably performed under the same conditions as the cleaning method described above in the section "Method for cleaning semiconductor substrate".

According to the method for producing a semiconductor substrate of the present invention, since there is a step in which unnecessary components can be removed while leaving necessary components using the above-described cleaning composition for semiconductor substrates, semiconductor substrates having finer metal wiring can be produced, and the integration of the semiconductor devices can be increased.

Examples

Hereinafter, the present invention will now be described in more detail with reference to Examples, but the present invention is not limited to these Examples.

<Analysis methods/evaluation methods>

(1) pH

The pH of the cleaning composition for semiconductor substrates was measured using a glass electrode method (F-55S desktop pH meter, manufactured by HORIBA, Ltd., Standard ToupH electrode 9165S-10D, temperature 25°C).

(2) Etching rate (ER)

(2-1) Etching rate (ER) of titanium nitride and low-dielectric-constant interlayer insulating film

A "wafer with a titanium nitride film" having a titanium nitride layer on a silicon wafer, and a "wafer with a TEOS film" having a plasma TEOS (PE-TEOS) layer, which is one type of low-dielectric-constant interlayer insulating film, on a silicon wafer were prepared.

Next, the thicknesses were measured. The thickness of the titanium nitride layer of the "wafer with a titanium nitride film" was measured using a fluorescent X-ray apparatus SEA1200VX (manufactured by SII Nanotechnology Co., Ltd.). The thickness of the PE-TEOS layer of the "wafer with a TEOS film" was measured using an optical film thickness meter n&k1280 (manufactured by n&k Technology).

Next, the cleaning composition for semiconductor substrates of the Examples and Comparative Examples was adjusted to 60°C, the wafers with each film were immersed for 1 to 5 minutes, then rinsed with ultrapure water at 25°C, and the thickness of each wafer was again measured by the above-described measurement method.

The etching rate (ER) (Å/min) of each material was calculated by dividing the difference in thickness before and after immersion in the cleaning composition for semiconductor substrates by the treatment time. In Table 1, the titanium nitride is listed as "TiN", and the low-dielectric-constant interlayer insulating film is listed as "TEOS".

(2-2) Measurement of molybdenum etching rate (ER)

A "wafer with a molybdenum film" having a molybdenum layer formed by PVD on a silicon wafer was prepared.

The cleaning composition for semiconductor substrates of the Examples and Comparative Examples was adjusted to 60°C, and the wafer with a molybdenum film was immersed for 1 to 5 minutes. The cleaning liquid after immersion (the "composition used" in the below expression) was diluted by a factor of 10 to 30 with 1% by mass ammonia water, and the molybdenum concentration was measured using an inductively coupled plasma emission spectrometer iCAP DUO-6300 (manufactured by Thermo Fisher Scientific Inc.). The etching rate (ER) (A/min) of the molybdenum was calculated by calculating the molybdenum concentration (Mo concentration) before dilution and substituting into the following formula. In Table 1, the molybdenum is listed as "Mo". In the following formula, "10.28 g/cm$^3$" is the density of molybdenum, and "wafer area" is the area of the molybdenum film on the wafer.

$$\text{ER (Å/min) of Mo} = \frac{\text{Mo concentration before dilution (μg/kg)} \times \text{amount of composition used (g)}}{10.28 \text{ (g/cm}^3) \times \text{wafer area (cm}^2)} \times \frac{1}{10} \times \frac{1}{\text{immersion time (min)}}$$

(3) Etching selectivity

The etching selectivity was evaluated by determining the etching rate ratios from the etching rates obtained by the above method.

The calculated etching rate ratios were as follows.

(3-1) Etching rate ratio of titanium nitride relative to molybdenum (TiN/Mo)

In each Example and Comparative Example, the etching rate of the titanium nitride (TiN) was divided by the etching rate of the molybdenum (Mo) to determine the etching rate ratio of the titanium nitride relative to the molybdenum (TiN/Mo). The larger this value is, the more the cleaning composition for semiconductor substrates can remove the titanium nitride while suppressing corrosion of the molybdenum. In other words, the larger this value is, the more the cleaning composition for semiconductor substrates can selectively remove the titanium nitride from a semiconductor substrate containing molybdenum.

(3-2) Etching rate ratio of titanium nitride relative to low-dielectric-constant interlayer insulating film (TiN/TEOS)

In each Example and Comparative Example, the etching rate of the titanium nitride (TiN) was divided by the etching rate of PE-TEOS (TEOS) to determine the etching rate ratio of the titanium nitride relative to the plasma TEOS which is a low-dielectric-constant interlayer insulating film (TiN/TEOS). The larger this value is, the more the cleaning composition for semiconductor substrates can remove the titanium nitride while suppressing corrosion of the low-dielectric-constant interlayer insulating film. In other words, the larger this value is, the more the cleaning composition for semiconductor substrates can selectively remove the titanium nitride from a semiconductor substrate containing a low-dielectric-constant interlayer insulating film.

<Cleaning composition for semiconductor substrates>

Example 1

Tetrafluoroboric acid (component (A)), boric acid (component (B)), potassium permanganate (component (C)), sulfuric acid, and ultrapure water (component (D)) were blended in the mass ratios shown in Table 1 to obtain a cleaning composition for semiconductor substrates.

Examples 2 to 8 and Comparative Examples 1 to 7

Cleaning compositions for semiconductor substrates were obtained in the same manner as in Example 1, except that the components and mass ratios of Example 1 were changed to the components and mass ratios shown in Table 1. It is noted that in Comparative Examples 4 to 7, component (B) was not added. In addition, in Examples 5 to 8 and Comparative Examples 1, 3, and 5 to 7, sulfuric acid was not added.

Each cleaning composition for semiconductor substrates was analyzed and evaluated using the methods described in the analysis methods and evaluation methods above. Table 1 shows the results of the analysis and evaluation of the cleaning compositions for semiconductor substrates obtained in the Examples and Comparative Examples.

In Table 1, for convenience, component (A) is listed as "fluorine compound", component (B) as "silicon compound etc.", and the molar ratio between component (A) and component (B), [(A)/(B)], is also listed as [(A)/(B)].

Table 1

| | Component (A) Fluorine compound | | Component (B) Silicon compound etc. | | (A)/(B) | Component (C) Oxidant | | Component (D) Ultrapure water | Sulfuric acid | Properties of cleaning composition | | Etching rate (ER) (Å/min) | | | Etching selectivity (ER ratio) | |
|---|---|---|---|---|---|---|---|---|---|---|---|---|---|---|---|---|
| | Kind | mass % | Kind | mass % | molar ratio | Kind | mass % | mass% | mass % | α | pH | TiN | Mo | TEOS | TiN/Mo | TiN/TEOS |
| Example 1 | tetrafluoroboric acid | 5.0 | boric acid | 1.0 | 3.5 | potassium permanganate | 0.0200 | 91.98 | 2.0 | 0.78 | 0.3 | 203 | 19 | 5 | 10.6 | 43.2 |
| Example 2 | hexafluorosilicic acid | 5.0 | sodium metasilicate | 1.0 | 4.2 | potassium permanganate | 0.0020 | 93.00 | 1.0 | 0.81 | 0.2 | 183 | 29 | 2 | 6.2 | 91.4 |
| Example 3 | hexafluorosilicic acid | 5.0 | silicon dioxide | 0.5 | 4.2 | potassium permanganate | 0.0010 | 89.50 | 5.0 | 0.81 | -0.3 | 139 | 22 | 5 | 6.3 | 28.2 |
| Example 4 | hexafluorosilicic acid | 5.0 | potassium silicate | 0.5 | 10.7 | potassium permanganate | 0.0010 | 91.50 | 3.0 | 0.91 | -0.4 | 151 | 15 | 8 | 9.8 | 18.0 |
| Example 5 | hexafluorosilicic acid | 5.0 | potassium silicate | 0.5 | 10.7 | vanadium(V) oxide | 0.0050 | 94.50 | - | 0.91 | -0.2 | 179 | 21 | 0 | 8.4 | 150 |
| Example 6 | hexafluorosilicic acid | 5.0 | potassium silicate | 1.0 | 5.4 | iodic acid | 0.0010 | 94.00 | - | 0.84 | 0.0 | 129 | 5 | 0 | 25.8 | 150 |
| Example 7 | hydrofluoric acid | 4.5 | boric acid | 4.5 | 3.1 | potassium permanganate | 0.0015 | 91.00 | - | 0.77 | -0.3 | 186 | 29 | 4 | 6.5 | 41.7 |
| Example 8 | hydrofluoric acid | 4.5 | boric acid | 6.0 | 2.3 | potassium permanganate | 0.0015 | 89.50 | - | 0.58 | 0.0 | 168 | 28 | 2 | 6.0 | 96.8 |
| Comparative Example 1 | hydrofluoric acid | 4.5 | boric acid | 1.0 | 13.9 | potassium permanganate | 0.0015 | 94.50 | - | 3.48 | 2.4 | 35 | 2 | 334 | 14.1 | 0.1 |
| Comparative Example 2 | hydrofluoric acid | 2.5 | boric acid | 1.0 | 7.7 | potassium permanganate | 0.0020 | 95.50 | 1.0 | 1.93 | 2.1 | 66 | 1 | 338 | 80.0 | 0.2 |
| Comparative Example 3 | hydrofluoric acid | 4.5 | boric acid | 3.0 | 4.6 | potassium permanganate | 0.0015 | 92.50 | - | 1.16 | 1.7 | 19 | 2 | 330 | 8.3 | 0.1 |
| Comparative Example 4 | hexafluorosilicic acid | 0.5 | - | - | - | potassium permanganate | 0.0020 | 98.50 | 1.0 | 1.00 | 0.9 | 172 | 33 | 8 | 5.3 | 21.2 |
| Comparative Example 5 | tetrafluoroboric acid | 1.0 | - | - | - | iodic acid | 0.0020 | 99.00 | - | 1.00 | 0.7 | 154 | 33 | 6 | 4.7 | 27.2 |
| Comparative Example 6 | hexafluorosilicic acid | 1.0 | - | - | - | vanadium(V) oxide | 0.01 | 98.99 | - | 1.00 | 1.1 | 187 | 55 | 3 | 3.4 | 55.0 |

EP 4 550 387 A1

(continued)

| | Component (A) Fluorine compound | | Component (B) Silicon compound etc. | | (A)/(B) | Component (C) Oxidant | | Component (D) Ultrapure water | Sulfuric acid | Properties of cleaning composition | | Etching rate (ER) (Å/min) | | | Etching selectivity (ER ratio) | |
|---|---|---|---|---|---|---|---|---|---|---|---|---|---|---|---|---|
| | Kind | mass % | Kind | mass % | molar ratio | Kind | mass % | mass% | mass % | α | pH | TiN | Mo | TEOS | TiN/Mo | TiN/TEOS |
| Comparative Example 7 | hexafluorosilicic acid | 1.0 | - | - | - | potassium permanganate | 0.01 | 98.99 | - | 1.00 | 1.2 | 343 | 175 | 4 | 2.0 | 92.8 |

As can be seen from Table 1, the cleaning composition for semiconductor substrates of the Examples can selectively remove titanium nitride from semiconductor substrates containing titanium nitride, molybdenum, and a low-dielectric-constant interlayer insulating film. Therefore, it is clear that by using the cleaning composition for semiconductor substrates of the present invention, it is possible to remove titanium nitride while suppressing corrosion of, in particular, molybdenum for which an anticorrosive agent is less effective. For that reason, the cleaning composition for semiconductor substrates of the present invention is suitable for the cleaning and production of semiconductor substrates having finer metal wiring.

**Claims**

1.  A cleaning composition for semiconductor substrates, comprising:

    a component (A): at least one selected from the group consisting of hydrofluoric acid, a salt of hydrofluoric acid, an acid having an anion represented by the following general formula (a) as a conjugate base, and a salt of an acid having an anion represented by the general formula (a) as a conjugate base,

    $$[MF_n]^{(n-k)-} \qquad (a);$$

    a component (B): a compound represented by the following general formula (b):

    $$[MO_m(OR)_{k-2m}]_x \qquad (b)$$

    wherein in formulas (a) and (b), M is at least one element selected from the group consisting of boron, silicon, zirconium, antimony, niobium, aluminum, phosphorus, and titanium, k is the oxidation number of M, m is an integer of 0 or more and k/2 or less, x is a positive integer, R is one selected from the group consisting of a hydrogen atom, an alkali metal, and an alkyl group, and n is a coordination number of the fluoride ion to M;
    a component (C): an oxidant; and
    a component (D): water,
    wherein $\alpha$ represented by the following Expression (I) is 0.2 or more and 1.1 or less,

    $$\alpha = \frac{[F]}{\sum(n(M) \cdot [M])} \qquad (I)$$

    wherein [F] is the molar concentration of the fluoride ion in the composition, [M] is the molar concentration of M in the composition, and n(M) is the coordination number of the fluoride ion to M.

2.  The cleaning composition for semiconductor substrates according to claim 1, wherein the component (A) comprises at least one selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid.

3.  The cleaning composition for semiconductor substrates according to claim 1 or 2, wherein the component (B) comprises at least one selected from the group consisting of boric acid, a salt of boric acid, silicon dioxide, silicic acid, a salt of silicic acid, orthosilicic acid, a salt of orthosilicic acid, an alkoxysilane, zirconium oxide, zirconic acid, and a salt of zirconic acid.

4.  The cleaning composition for semiconductor substrates according to any one of claims 1 to 3, wherein the component (C) is at least one selected from the group consisting of vanadium(V) oxide, vanadic acid (V), a salt of vanadic acid (V), permanganic acid, a salt of permanganic acid, iodic acid, a salt of iodic acid, orthoperiodic acid, a salt of orthoperiodic acid, perchloric acid, a salt of perchloric acid, diammonium cerium(IV) nitrate, ammonium iron(III) sulfate, ammonium peroxodisulfate, iron(III) chloride, ammonium nitrate, t-butyl hydroperoxide, N-methylmorpholine N-oxide, and trimethylamine N-oxide.

5.  The cleaning composition for semiconductor substrates according to any one of claims 1 to 4, wherein the cleaning composition is substantially free of hydrogen peroxide, p-benzoquinone, copper(II) nitrate, sodium peroxoborate, bromic acid, and a salt of bromic acid.

6. The cleaning composition for semiconductor substrates according to any one of claims 1 to 5, wherein the cleaning composition for semiconductor substrates has a pH of 2 or less.

7. The cleaning composition for semiconductor substrates according to any one of claims 1 to 6, wherein the cleaning composition is used for removing titanium nitride from semiconductor substrates containing titanium nitride, molybdenum and a low-dielectric-constant interlayer insulating film.

8. The cleaning composition for semiconductor substrates according to any one of claims 1 to 7, wherein a content of the component (A) is 0.5 to 10% by mass with respect to the total amount of the cleaning composition for semiconductor substrates.

9. The cleaning composition for semiconductor substrates according to any one of claims 1 to 8, wherein a content of the component (B) is 0.05 to 10% by mass with respect to the total amount of the cleaning composition for semiconductor substrates.

10. The cleaning composition for semiconductor substrates according to any one of claims 1 to 9, wherein a content of the component (C) is 0.0005 to 1% by mass with respect to the total amount of the cleaning composition for semiconductor substrates.

11. The cleaning composition for semiconductor substrates according to any one of claims 1 to 10, wherein the component (A) is at least one selected from the group consisting of an acid having an anion represented by the general formula (a) as a conjugate base and a salt of an acid having an anion represented by the general formula (a) as a conjugate base, and a ratio between the content (mol) of the component (A) and the content (mol) of the component (B), [(A)/(B)], is 1 to 100.

12. The cleaning composition for semiconductor substrates according to any one of claims 1 to 11, wherein when a substrate containing molybdenum and titanium nitride is immersed in the cleaning composition for semiconductor substrates and stored at 60°C, titanium nitride can be removed at a removal rate of 30 Å/min or more, and a ratio between the removal rate of the titanium nitride and the removal rate of the molybdenum is 3 or more.

13. The cleaning composition for semiconductor substrates according to any one of claims 1 to 12, wherein when a substrate containing a low-dielectric-constant interlayer insulating film and titanium nitride is immersed in the cleaning composition for semiconductor substrates and stored at 60°C, the titanium nitride can be removed at a removal rate of 30 Å/min or more, and a ratio between the removal rate of the titanium nitride and the removal rate of the low-dielectric-constant interlayer insulating film is 10 or more.

14. The cleaning composition for semiconductor substrates according to any one of claims 7 to 13, wherein the low-dielectric-constant interlayer insulating film is a PE-TEOS film.

15. A method for cleaning a semiconductor substrate, comprising contacting the cleaning composition for semiconductor substrates according to any one of claims 1 to 14 with a substrate containing titanium nitride, molybdenum, and a low-dielectric-constant interlayer insulating film.

16. A method for producing a semiconductor substrate, comprising a step of contacting the cleaning composition for semiconductor substrates according to any one of claims 1 to 14 with a substrate containing titanium nitride, molybdenum, and a low-dielectric-constant interlayer insulating film.

## INTERNATIONAL SEARCH REPORT

International application No.

**PCT/JP2023/023715**

### A. CLASSIFICATION OF SUBJECT MATTER

*H01L 21/304*(2006.01)i
FI:   H01L21/304 647Z

According to International Patent Classification (IPC) or to both national classification and IPC

### B. FIELDS SEARCHED

Minimum documentation searched (classification system followed by classification symbols)

H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2010-515245 A (ADVANCED TECHNOLOGY MATERIALS, INC) 06 May 2010 (2010-05-06)<br>paragraphs [0027]-[0101], fig. 1-3 | 1-6, 8-16 |
| X | WO 2019/026677 A1 (MITSUBISHI GAS CHEMICAL CO) 07 February 2019 (2019-02-07)<br>paragraphs [0020]-[0046], fig. 1-2 | 1-6, 8-14 |
| X | WO 2018/061670 A1 (FUJIFILM CORP) 05 April 2018 (2018-04-05)<br>paragraphs [0011]-[0160], fig. 1 | 1-5, 7-10, 12-16 |
| Y | | 4, 10 |
| X | JP 2016-527707 A (ADVANCED TECHNOLOGY MATERIALS, INC) 08 September 2016 (2016-09-08)<br>paragraphs [0009]-[0063] | 1-5, 7-9, 11-16 |
| Y | | 4, 6, 10 |
| Y | WO 2015/111684 A1 (MITSUBISHI GAS CHEMICAL CO) 30 July 2015 (2015-07-30)<br>paragraphs [0012]-[0074], fig. 1 | 4, 6, 10 |

☑ Further documents are listed in the continuation of Box C.     ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **01 September 2023** | **12 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

# EP 4 550 387 A1

<table>
<tr><td colspan="3" align="center">INTERNATIONAL SEARCH REPORT</td><td>International application No.<br><br>**PCT/JP2023/023715**</td></tr>
</table>

**C.  DOCUMENTS CONSIDERED TO BE RELEVANT**

| Category* | Citation of document, with indication, where appropriate, of the relevant passages | Relevant to claim No. |
|---|---|---|
| A | WO 2021/176903 A1 (FUJIFILM CORP) 10 September 2021 (2021-09-10)<br>entire text, all drawings | 1-16 |
| A | JP 2013-533631 A (ADVANCED TECHNOLOGY MATERIALS, INC) 22 August 2013 (2013-08-22)<br>entire text | 1-16 |
| P, X | JP 2023-36214 A (FUJIFILM CORP) 14 March 2023 (2023-03-14)<br>paragraphs [0011]-[0189] | 1-16 |

Form PCT/ISA/210 (second sheet) (January 2015)

INTERNATIONAL SEARCH REPORT

Information on patent family members

International application No.

**PCT/JP2023/023715**

| Patent document cited in search report | | | Publication date (day/month/year) | Patent family member(s) | | | Publication date (day/month/year) |
|---|---|---|---|---|---|---|---|
| JP | 2010-515245 | A | 06 May 2010 | US paragraphs [0031]-[0100], fig. 1-3 | 2010/0176082 | A1 | |
| | | | | WO | 2008/080096 | A2 | |
| | | | | CN | 101605869 | A | |
| | | | | TW | 200849389 | A | |
| | | | | SG | 177201 | A1 | |
| WO | 2019/026677 | A1 | 07 February 2019 | US paragraphs [0021]-[0068], fig. 1-2 | 2021/0087501 | A1 | |
| | | | | EP | 3664125 | A1 | |
| | | | | CN | 110945631 | A | |
| | | | | KR | 10-2020-0034997 | A | |
| | | | | TW | 201910501 | A | |
| WO | 2018/061670 | A1 | 05 April 2018 | US paragraphs [0059]-[0458], fig. 1 | 2019/0177670 | A1 | |
| | | | | KR | 10-2019-0036547 | A | |
| | | | | TW | 201819613 | A | |
| JP | 2016-527707 | A | 08 September 2016 | US paragraphs [0009]-[0063] | 2016/0130500 | A1 | |
| | | | | WO | 2014/197808 | A1 | |
| | | | | EP | 3004287 | A1 | |
| | | | | TW | 201504397 | A | |
| | | | | KR | 10-2016-0014714 | A | |
| | | | | CN | 105683336 | A | |
| WO | 2015/111684 | A1 | 30 July 2015 | US paragraphs [0021]-[0079], fig. 1 | 2016/0281038 | A1 | |
| | | | | DE | 112015000506 | T5 | |
| | | | | CN | 105981136 | A | |
| | | | | KR | 10-2016-0111903 | A | |
| | | | | TW | 201533221 | A | |
| WO | 2021/176903 | A1 | 10 September 2021 | TW | 202140753 | A | |
| JP | 2013-533631 | A | 22 August 2013 | US entire text | 2013/0296214 | A1 | |
| | | | | WO | 2012/009639 | A2 | |
| | | | | EP | 2593964 | A2 | |
| | | | | TW | 201209156 | A | |
| | | | | CN | 103003923 | A | |
| | | | | SG | 187551 | A1 | |
| | | | | KR | 10-2013-0088847 | A | |
| JP | 2023-36214 | A | 14 March 2023 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015111684 A
- JP 2015506583 A
- JP 2016510175 A
- JP 2016527707 A